# FASCICULE DE BREVET EUROPEEN

(11) **EP 1 746 643 B1**
(45) Date de publication et mention de la délivrance du brevet: **02.09.2015**
(21) Numéro de dépôt: 06291159.9
(22) Date de dépôt: 18.07.2006
(51) Int. Cl.: H01L 21/762

(54) **Procédé de réalisation d'un transistor MOS.**
Herstellungsverfahren eines MOS-Transistors.
Process of making a MOS transistor.

(30) Priorité: 18.07.2005 FR 0507598
(43) Date de publication de la demande: 24.01.2007
(73) Titulaire: STMicroelectronics (Crolles 2) SAS, 38920 Crolles (FR); Commissariat à l'Énergie Atomique et aux Énergies Alternatives, 75015 Paris (FR)
(72) Inventeur: Coronel, Philippe, 38530 Barraux (FR); Gallon, Claire, 38100 Grenoble (FR); Fenouillet-Beranger, Claire, 38100 Grenoble (FR)
(74) Mandataire: Zapalowicz, Francis

(56) Documents cités:
- EP-A- 0 845 803
- EP-A- 1 237 185
- EP-A2- 1 365 447
- US-A- 5 436 174
- US-A1- 2004 195 623
- US-A1- 2004 242 015
- US-A1- 2005 151 222
- HUDA M Q ET AL: "Thick elevation of silicon on patterned structure using ion implantation induced selective etching" NUCLEAR INSTRUMENTS & METHODS IN PHYSICS RESEARCH, SECTION - B: BEAM INTERACTIONS WITH MATERIALS AND ATOMS, ELSEVIER, AMSTERDAM, NL, vol. 216, février 2004 (2004-02), pages 20-24, XP004489473 ISSN: 0168-583X

## Description

L'invention concerne les circuits intégrés, et plus particulièrement les transistors de type MOS.

La fabrication des transistors réalisés en technologie MOS se heurte à plusieurs problèmes, parmi lesquels on note les effets de canaux courts.

Tel est en particulier le cas des transistors réalisés sur substrat en silicium massif.

On rappelle ici qu'un canal court, c'est-à-dire présentant une distance (longueur) très faible entre la source et le drain du transistor, conduit à une diminution de la tension de seuil du transistor, ce qui peut entraîner à l'extrême limite l'obtention d'un transistor très difficilement contrôlable.

Les transistors réalisés selon la technologie SOI (« Silicon On Insulator »), en particulier la technologie à déplétion totale, outre les avantages liés à l'élaboration d'architecture plus compacte que dans un substrat en silicium massif, permet de réduire les effets de canaux courts.

Selon cette technique, le substrat est réalisé en silicium et est formé au-dessus d'une couche d'oxyde enterré, généralement dénommée par les anglo-saxons de BOX (« Buried OXide »). Voir par exemple le document US2005/0151222. Or, selon la structure SOI, l'épaisseur du film de silicium et de la couche d'oxyde enterré est relativement faible. En effet, la couche d'oxyde enterré est généralement comprise entre 1450 et 4000 Å. Tel est également le cas du film de SOI dont l'épaisseur est généralement de l'ordre de 200 Å.

Il a été constaté que l'épaisseur réduite de la couche d'oxyde enterré entraîne une réduction du couplage électrostatique entre la région de drain et la région de source, ce qui permet de diminuer le phénomène d'effets de canaux courts.

Au cours des opérations de gravure mises en oeuvre lors de la réalisation de la région d'isolation définissant la zone active dans laquelle est défini le transistor, la couche d'oxyde enterré est susceptible d'être attaquée, ce qui entraîne une consommation excessive de matériau d'isolation pour la réalisation de la région d'isolation STI (« Shallow Trench Isolation »).

De surcroît, il a été également constaté que selon cette technique, le film de SOI est disposé en saillie au-dessus de la couche d'oxyde enterré, de sorte que la région de grille est également formée latéralement de part et d'autre de la région de SOI, ce qui tend à créer des transistors parasites sur les flancs du SOI recouverts du matériau de grille.

Le but de l'invention est donc de pallier les inconvénients des techniques de fabrication des transistors MOS réalisés en technologie SOI.

L'invention a donc pour objet, selon un premier aspect, un procédé de réalisation d'un transistor MOS sur un substrat en silicium SOI placé sur une couche d'oxyde enterré, ledit transistor étant réalisé dans une zone active du substrat délimitée par une région isolante, le procédé comprenant les étapes décrites dans la revendication 1.

Ainsi, grâce à la réalisation de la grille par dépôt d'un matériau de grille sur le matériau diélectrique ou à forte permittivité, celui-ci pouvant être gravé sélectivement par rapport au silicium, la gravure active du silicium peut alors être effectuée postérieurement à la grille. L'étape de gravure du silicium, mise en oeuvre selon les procédés conventionnels, habituellement réalisée en début du procédé et tendant à attaquer la couche d'oxyde enterré, est supprimée. En outre, la grille peut être formée sur une surface parfaitement plane, ce qui permet d'éviter la formation de transistors parasites sur les flancs du SOI.

Dans un mode de mise en oeuvre du procédé selon l'invention, on procède à une implantation ionique de germanium à l'endroit de la future région isolante, on recuit le substrat de manière à provoquer une transformation localisée du substrat en alliage de silicium-germanium, on dépose, sur le substrat, une couche de matériau de grille avec interposition d'une couche d'oxyde de grille, on procède à la gravure de la grille puis on effectue une gravure à l'endroit de la zone d'alliage de silicium-germanium de manière à retirer ledit alliage, et l'on dépose ledit matériau diélectrique dans la zone du substrat gravé.

De préférence, préalablement à la gravure du substrat, on forme des espaceurs pour la grille.

Par exemple, le diélectrique déposé est un diélectrique du même type que celui des espaceurs.

Dans un exemple de mise en oeuvre du procédé, l'étape de gravure est une attaque isotrope, par plasma ou par voie humide.

Cette étape de gravure peut être effectuée de manière à graver l'alliage de silicium-germanium jusqu'à la couche d'oxyde sous-jacente.

Un circuit intégré ne faisant pas partie de l'invention est décrit et comporte un transistor MOS comprenant une région de grille formée au-dessus d'un substrat en silicium SOI déposé sur une couche d'oxyde enterré entre des zones mutuellement opposées d'une région isolante délimitant une zone active dans laquelle est formé le transistor.

Selon une caractéristique générale de ce circuit, la surface supérieure de la région isolante affleure la partie supérieure du substrat SOI, de manière que la région de grille est disposée sur une surface plane.

D'autres buts, caractéristiques et avantages de l'invention apparaîtront à la lecture de la description suivante, donnée uniquement à titre d'exemple non limitatif, et faite en référence aux dessins annexés, sur lesquels :
- La figure 1 est une vue en coupe d'un dispositif à semi-conducteur en cours de réalisation, montrant la réalisation de l'active au moyen d'un procédé selon l'état de la technique ;
- La figure 2 est une autre vue en coupe d'un dispositif à semi-conducteur postérieurement à une étape de nettoyage avant réalisation de la région de grille au moyen d'un procédé selon l'état de la technique ;
- La figure 3 est une vue en coupe d'un dispositif à semi-conducteur au cours d'une première phase de réalisation d'une région d'isolation au moyen d'un procédé conforme à l'invention ;
- La figure 4 est une vue de dessus d'un dispositif à semi-conducteur en cours de réalisation au moyen d'un procédé selon l'invention, après transformation de la région d'isolation en alliage de silicium-germanium et formation de la région de grille ;
- La figure 5 est une vue en coupe selon une autre direction du dispositif de la figure 4, montrant la réalisation des espaceurs ;
- La figure 6 est une vue en coupe du dispositif des figures 3 à 5, après l'étape de gravure ; et
- La figure 7 montre le dispositif de la figure 6, après l'étape de remplissage de la cavité formée après l'étape de gravure.

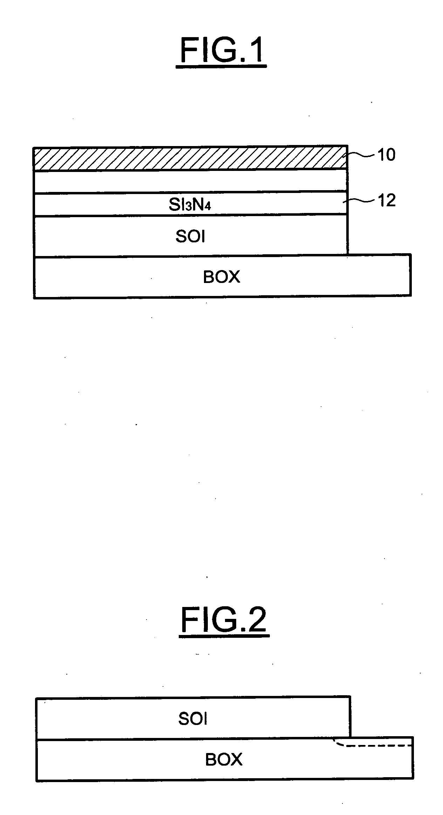

Sur les figures 1 et 2, on a représenté deux phases consécutives de réalisation d'un dispositif à semi-conducteur au moyen d'un procédé selon l'état de la technique.

Tel que représenté sur ces figures, le procédé consiste à réaliser des transistors MOS sur un substrat en silicium de type SOI (« Silicon On Insulator ») disposé sur une couche d'oxyde enterré BOX (« Buried OXide »).

Selon ce type de technologie, la couche d'oxyde enterré présente une épaisseur de l'ordre de 1500 Å.

L'étape de procédé représentée sur la figure 1 correspond à une phase de photolithographie active préalable à un dépôt de matériau de grille sur le substrat SOI.

A ce stade, le substrat SOI est recouvert d'une couche de résine photo-sensible 10 avec interposition d'un masque dur 12 et d'une couche 13 de nitrure Si₃N₄.

En référence à la figure 2, avant dépôt du matériau de grille, il convient de procéder à une phase de nettoyage. Comme le montre la figure 2, cette phase de nettoyage engendre une attaque non négligeable de l'oxyde enterré BOX sur une épaisseur pouvant atteindre 100, voire 150 Å.

Comme on le conçoit, selon cette technique, il n'est pas possible de réaliser des transistors sur un substrat déposé sur une couche d'oxyde enterré d'une épaisseur de l'ordre de 200 Å afin de limiter les couplages électriques et la création de lignes de champ entre le drain et la source du transistor à travers la couche de BOX et d'éviter l'intégration standard de la région d'isolation STI.

En outre, comme le révèle la figure 2, selon cette technique, le matériau de grille est déposé sur une surface non plane, ce qui, comme mentionné précédemment, engendre l'apparition de transistors parasites latéraux.

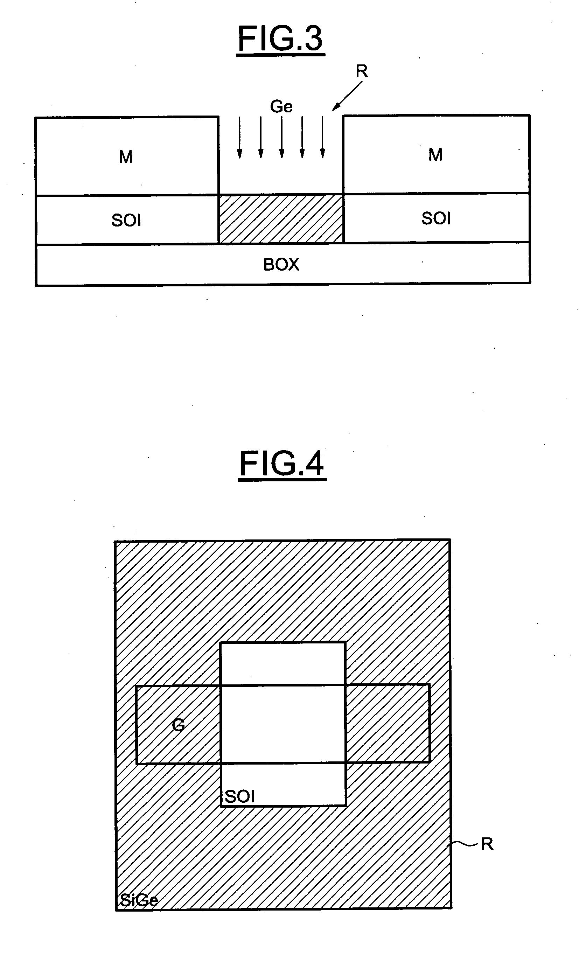

On va décrire, en référence aux figures 3 à 7, un procédé de réalisation de transistors MOS selon l'invention permettant de pallier ces inconvénients.

Le procédé décrit sur ces figures consiste à réaliser des transistors MOS sur un substrat semi-conducteur SOI disposé sur une couche d'oxyde enterré BOX.

Comme cela sera décrit en détail par la suite, ce procédé permet la réalisation de transistors sur une couche d'oxyde d'épaisseur de l'ordre de 200 Å disposée au-dessus d'une couche d'oxyde enterré d'épaisseur également de l'ordre de 200 Å, voire 100 Å.

En se référant tout d'abord à la figure 3, la première phase du procédé consiste en une mise en oeuvre d'une étape de photolithographie active conventionnelle, au cours de laquelle on dépose, à l'endroit d'une zone du substrat destinée à constituer la zone active dans laquelle un transistor sera formé, un masque de photolithographie M. Un tel masque M est réalisé par dépôt d'une résine appropriée pour l'utilisation envisagée selon une technique connue en elle-même.

En se référant également à la figure 4, après dépôt du masque, on procède à une implantation ionique de germanium dans une zone du substrat située à l'endroit de la région isolante R délimitant la zone active.

On enlève la résine puis on recuit le substrat pour obtenir une formation localisée d'un alliage de silicium-germanium, à l'endroit de la région d'isolation R.

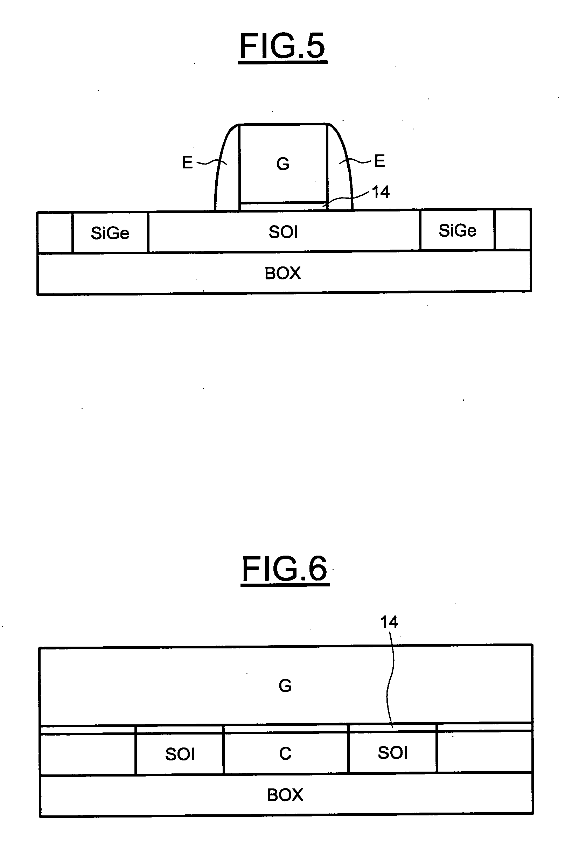

En se référant également à la figure 5, on procède alors à la réalisation de la grille G.

Cette phase de formation de la grille est réalisée de manière conventionnelle et ne sera donc pas décrite en détail par la suite.

On notera cependant qu'elle consiste essentiellement à déposer une couche d'oxyde de grille 14 sur le substrat SOI, puis à déposer une couche de matériau de grille, par exemple du silicium polycristallin, sur la couche d'oxyde de grille. On procède alors à une étape de photolithographie suivie d'une étape de gravure, de manière à ne laisser subsister qu'un dépôt d'oxyde de grille recouvert de matériau de grille qu'à l'endroit de la région de grille pour le transistor à former.

On procède alors à un dépôt, puis à une gravure de matériau pour espaceurs afin de réaliser les espaceurs E.

Lors de l'étape suivante, c'est-à-dire après réalisation de la grille munie de ces espaceurs E, on procède à un retrait sélectif de l'alliage de silicium-germanium puis plus tard à une phase de siliciuration. Différentes techniques peuvent être utilisées pour le retrait sélectif de cet alliage de silicium-germanium. On peut ainsi, par exemple, utiliser une attaque plasma ou humide isotrope, une attaque chimique pouvant également être mise en oeuvre à cet effet.

On notera que l'implantation ionique de germanium dans la région R du substrat destinée à constituer la région isolante, a été effectuée afin de former ultérieurement une zone localisée d'un alliage de silicium-germanium, lequel peut être sélectivement gravé par rapport au silicium du substrat SOI. Aussi, en variante, il est possible de réaliser une implantation localisée de tout autre matériau pouvant être sélectivement gravé par rapport au silicium. Toutefois, l'utilisation d'un alliage de silicium-germanium est avantageuse dans la mesure où la zone en alliage SiGe peut alors être réalisée aisément et relativement rapidement par des techniques conventionnelles.

A l'issue de cette phase de gravure, le dispositif se situe dans l'étape visible à la figure 6 dans laquelle une cavité a été crée à l'endroit du silicium-germanium.

Lors de l'étape suivante, on procède à un dépôt de diélectrique pour remplir les cavités créées à l'issue de l'étape de gravure.

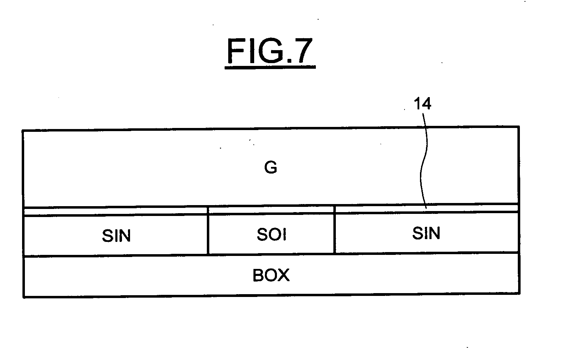

En référence à la figure 7, on procède à un dépôt d'un diélectrique. Par exemple, ce diélectrique peut être du même type que celui utilisé pour la réalisation des espaceurs E de sorte que les espaceurs peuvent également être formés au cours de cette étape. Par exemple, le diélectrique remplissant la cavité C est constitué de nitrure de silicium. Diverses techniques peuvent être utilisées pour procéder à cette étape. On peut ainsi, par exemple, procéder au dépôt de diélectrique en utilisant une technique de dépôt chimique en phase vapeur (CVD) ou à un dépôt chimique en phase vapeur à basse pression (LPCVD). On obtient alors le circuit intégré visible sur la figure 7, dans lequel les cavités sont remplies de nitrure.

Comme on le voit sur cette figure, la face supérieure de la région R d'isolation affleure la face supérieure du silicium SOI.

Enfin, de manière conventionnelle en SOI, il convient alors de former les régions de source et de drain par des techniques conventionnelles de photolithographie, d'implantation ionique et de siliciuration, puis de recouvrir l'ensemble par une couche de diélectrique PMD (Pré-Métal Diélectrique).

Grâce au procédé qui vient d'être décrit, il a ainsi été possible de réaliser une région de grille sur un substrat SOI déposé sur une couche d'oxyde enterré BOX relativement mince, c'est-à-dire de l'ordre de 200 Å, dans la mesure où aucune étape de procédé ne conduit à une attaque de la couche d'oxyde BOX. En outre, la grille s'étend selon une surface parfaitement plane, évitant ainsi la création de transistors parasites latéraux.

De surcroît, le procédé selon l'invention permet d'obtenir les avantages suivants :
- grâce à l'invention, il n'est pas nécessaire de prévoir une étape de formation d'un module STI pour réaliser la région d'isolation,
- la région d'isolation proprement dite peut être formée après la réalisation de la grille,
- le procédé, et en particulier le dépôt de diélectrique, peut s'effectuer à basse température, adaptable à différentes technologies,
- le procédé permet de contraindre le canal du transistor par dépôt, par exemple, de nitrure de silicium SiN tensile ou compressif au niveau de la région d'isolation.
- L'intérêt d'avoir du SiGe permet, entre autre, d'avoir un matériau monocristallin pour la croissance de l'oxyde de grille et de limiter les problèmes de fiabilité d'oxyde par rapport à un matériau par exemple de type Si₃N₄.

## Revendications

1. Procédé de réalisation d'un transistor MOS sur un substrat en silicium (SOI) placé sur une couche d'oxyde enterrré (Box), ledit transistor étant réalisé dans une zone active de substrat délimitée par une région isolante (R), le procédé comprenant les étapes de :
1. délimitation de la région isolante réalisée en procédant à une formation localisée d'une zone en matériau apte à être gravé sélectivement par rapport au silicium et ensuite ;
2. réalisation d'une région de grille (G) et de régions de source et de drain qui délimitent entre elles un canal de sorte que la région de grille s'étende au-dessus du canal et ensuite ;
3. gravure sélective dudit matériau apte à être gravé sélectivement par rapport au silicium, et déposition d'un matériau diélectrique à l'endroit de la gravure.

2. Procédé selon la revendication 1, **caractérisé en ce que** l'on procède à une implantation ionique de germanium à l'endroit de la région isolante (R), on recuit le substrat (SOI) de manière à provoquer une transformation localisée de silicium en alliage de silicium-germanium, on dépose, sur le substrat, une couche de matériau de grille avec interposition d'une couche d'oxyde de grille (14), on procède à une étape de gravure à l'endroit de la zone d'alliage de silicium-germanium, de manière à retirer ledit alliage, et l'on dépose ledit matériau diélectrique dans la zone gravée.

3. Procédé selon la revendication 2, **caractérisé en ce que** préalablement à la gravure du silicium-germanium, on forme des espaceurs (E) pour la grille.

4. Procédé selon la revendication 3, **caractérisé en ce que** le diélectrique déposé est un diélectrique du même type que celui des espaceurs.

5. Procédé selon l'une quelconque des revendications 2 à 4, **caractérisé en ce que** l'étape de gravure est une attaque isotrope, par plasma ou par voie humide.

6. Procédé selon l'une quelconque des revendications 2 à 5, **caractérisé en ce que** l'étape de gravure est effectuée de manière à graver l'alliage de silicium-germanium jusqu'à la couche d'oxyde sous-jacente.

7. Procédé selon l'une des revendications 4 à 6, **caractérisé en ce que** le diélectrique est du nitrure de silicium.

## Patentansprüche

1. Verfahren zur Herstellung eines MOS-Transistors auf einem Siliciumsubstrat (SOI), angeordnet auf einer Schicht aus vergrabenem Oxid (Buried Oxide = Box), wobei der Transistor in einer aktiven Zone des Substrats hergestellt wird, die durch eine isolierende Region (R) definiert wird, wobei das Verfahren die folgenden Schritte umfasst:
1. Definieren der isolierenden Region, die hergestellt wird, indem lokal eine Zone aus einem Material gebildet wird, das bezogen auf Silicium selektiv geätzt werden kann und anschließend
2. Herstellen einer Gate-Region (G) und von Source- und Drain-Regionen, die zwischen sich einen Kanal definieren, so dass sich die Gate-Region oberhalb des Kanals erstreckt, und anschließend
3. selektives Ätzen des Materials, das bezogen auf Silicium selektiv geätzt werden kann, und Abscheiden eines dielektrischen Materials an der geätzten Stelle.

2. Verfahren nach Anspruch 1, **dadurch gekennzeichnet, dass** eine Germaniumionenimplantation an der Stelle der isolierenden Region (R) durchgeführt wird, das Substrat (SOI) getempert wird, um eine lokale Transformation von Silicium in eine Silicium-Germanium-Legierung zu bewirken, auf dem Substrat eine Schicht aus Gate-Material abgeschieden wird, mit Zwischenschaltung einer Gate-Oxidschicht (14), ein Schritt zum Ätzen an der Stelle der Silicium-Germanium-Legierungszone durchgeführt wird, um die Legierung zu entfernen, und das dielektrische Material in der geätzten Zone abgeschieden wird.

3. Verfahren nach Anspruch 2, **dadurch gekennzeichnet, dass** vor dem Ätzen des Silicium-Germaniums Spacer (E) für das Gate gebildet werden.

4. Verfahren nach Anspruch 3, **dadurch gekennzeichnet, dass** das abgeschiedene Dielektrikum ein Dielektrikum vom gleichen Typ wie das der Spacer ist.

5. Verfahren nach einem der Ansprüche 2 bis 4, **dadurch gekennzeichnet, dass** es sich bei dem Schritt zum Ätzen um isotropes Plasmaätzen oder isotropes Nassätzen handelt.

6. Verfahren nach einem der Ansprüche 2 bis 5, **dadurch gekennzeichnet, dass** der Schritt zum Ätzen derart ausgeführt wird, dass die Silicium-Germanium-Legierung bis auf die darunter liegende Oxidschicht weggeätzt wird.

7. Verfahren nach einem der Ansprüche 4 bis 6, **dadurch gekennzeichnet, dass** es sich bei dem Dielektrikum um Siliciumnitrid handelt.

## Claims

1. Process for producing an MOS transistor on a silicon substrate (SOI) placed on a buried oxide layer (BOX), said transistor being produced in an active substrate zone defined by an isolating region (R), the process comprising the steps of:
1. definition of the isolating region, which is produced by localized formation of a zone of material that can be selectively etched with respect to silicon; and then
2. production of a gate region (G) and source and drain regions, which between them define a channel so that the gate region extends above the channel; and then
3. selective etching of said material that can be selectively etched with respect to silicon and deposition of a dielectric material in the etched feature.

2. Process according to Claim 1, **characterized in that** a germanium ion implantation is carried out in the isolating region (R), the substrate (SOI) is annealed so as locally to convert silicon into a silicon-germanium alloy, a layer of gate material is deposited on the substrate, with interposition of a gate oxide layer (14), an etching step is carried out in the silicon-germanium alloy zone, so as to remove said alloy, and said dielectric material is deposited in said etched zone.

3. Process according to Claim 2, **characterized in that** spacers (E) for the gate are formed before the silicon-germanium is etched.

4. Process according to Claim 3, **characterized in that** the dielectric deposited is a dielectric of the same type as that of the spacers.

5. Process according to any one of Claims 2 to 4, **characterized in that** the etching step is either an isotropic plasma etching step or an isotropic wet etching step.

6. Process according to any one of Claims 2 to 5, **characterized in that** the etching step is carried out so as to etch the silicon-germanium alloy down to the underlying oxide layer.

7. Process according to one of Claims 4 to 6, **characterized in that** the dielectric is silicon nitride.
